## Europäisches Patentamt
## European Patent Office
## Office européen des brevets

(19)

(11) Numéro de publication: **0 108 676**
**B1**

(12)

# FASCICULE DE BREVET EUROPEEN

(45) Date de publication du fascicule du brevet:
**09.04.86**

(21) Numéro de dépôt: 83402075.2

(22) Date de dépôt: 25.10.83

(51) Int. Cl.⁴: **G 01 R 19/00**

(54) **Appareil de mesure de courants très faibles.**

(30) Priorité: **04.11.82 FR 8218498**

(43) Date de publication de la demande:
**16.05.84 Bulletin 84/20**

(45) Mention de la délivrance du brevet:
**09.04.86 Bulletin 86/15**

(84) Etats contractants désignés:
**DE FR GB IT NL**

(56) Documents cités:
**US - A - 4 357 685**

**PROC. IEE, vol. 126, no. 11R, novembre 1979, pages
1053-1068, Stevenage, GB, R.W.J. BARKER: "Modern
electrometer techniques"**

(73) Titulaire: **SOCIETE POUR L'ETUDE ET LA FABRICATION
DE CIRCUITS INTEGRES SPECIAUX - E.F.C.I.S.,
17, avenue des Martyrs, F-38100 Grenoble (FR)**

(72) Inventeur: **Borel, Joseph, THOMSON-CSF SCPI 173, bld
Haussmann, F-75379 Paris Cedex 08 (FR)**

(74) Mandataire: **Guérin, Michel et al, THOMSON-CSF
SCPI 19, avenue de Messine, F-75008 Paris (FR)**

LIBER, STOCKHOLM 1986

## Description

La présente invention concerne la mesure de courants très faibles pouvant descendre au dessous du picoampère ($10^{-12}$ ampère), l'application de cette mesure étant par exemple la mesure de courants photométriques en lumière faible, ou encore la détection d'un courant résultant de l'ionisation de particules dans une chambre de détection (telle que celles que l'on utilise pour la détection de fumées).

On a déjà proposé des circuits de mesure de courants faibles dont le principe est le suivant: une jonction semiconductrice collecte des charges électriques dont le flux définit le courant à mesurer; la différence de potentiel aux bornes de la jonction est appliquée à un amplificateur, lequel commande un convertisseur tension-fréquence qui lui-même commande un convertisseur fréquence-courant dont la sortie est appliquée à la jonction semiconductrice pour établir dans celle-ci un courant de compensation dans un sens opposé au courant à mesurer; le système est bouclé de manière à tendre à ramener à zéro la différence de potentiel aux bornes de la jonction, et la mesure de courant s'effectue par mesure de la fréquence de sortie du convertisseur tension-fréquence.

L'inconvénient essentiel de cette structure est l'existence de courants de fuite non négligeables dans la jonction, le courant de compensation n'étant pas égal au courant collecté qu'on cherche à mesurer, et la mesure étant sans signification pour des courants à mesurer de l'ordre du picoampère ou au dessous.

La présente invention propose une structure d'appareil de mesure qui réduit pratiquement à zéro tous les courants de fuite et qui permet d'établir un courant de compensation effectivement égal au courant à mesurer même pour des valeurs de ce courant bien inférieures au picoampère.

L'appareil de mesure selon l'invention fonctionne non pas selon un principe de compensation du courant s'écoulant dans une jonction semiconductrice, mais plutôt par le moyen d'une compensation de la quantité de charges s'accumulant dans une électrode conductrice de collection de charges, isolée électriquement du reste du circuit par une très haute impédance en courant continu; la compensation s'effectue par injection de charges électriques à travers une couche isolante mince qui maintient cette haute impédance.

Le degré de compensation des charges est par ailleurs examiné en reliant l'électrode de collection de charges à la grille d'un transistor à effet de champ à grille isolée et en examinant les variations de courant à travers source et drain de ce transistor sous l'effet de l'injection des charges de compensation. La très haute impédance vue de l'électrode collectrice est également maintenue à travers l'isolant de grille de ce transistor.

Ainsi, la structure de l'appareil de mesure de courant selon l'invention comprend essentiellement:

— une électrode conductrice de collection de charges électriques dont le flux constitue le courant à mesurer;

— un moyen de détection de la quantité de charges accumulées dans l'électrode de collection, ce moyen comprenant un transistor à effet de champ à grille isolée dont la grille est électriquement reliée à l'électrode de collection;

— un circuit d'injection de charges de compensation comprenant au moins une couche conductrice reliée à l'électrode de collection et une zone semiconductrice d'injection de porteurs, cette zone étant séparée de la couche conductrice par une couche isolante mince, et un moyen pour communiquer à des porteurs de la zone semiconductrice une énergie suffisante pour leur permettre de traverser l'épaisseur de la couche isolante mince, ce moyen fonctionnant pendant des intervalles de temps de durée et/ou de fréquence fonction du courant passant dans le transistor à effet de champ;

— l'électrode de collection de charges étant maintenue isolée en courant continu du reste du circuit par des couches isolantes incluant ladite couche isolante mince et l'isolant de grille du transistor du moyen de détection.

Dans cette structure, l'électrode de collection de charges est bien isolée par une très haute impédance aussi bien vis à vis du circuit d'injection de charges (à travers la couche isolante mince) que vis à vis de la détection de la compensation (à travers l'isolement de grille du transistor de détection), ce qui n'était pas le cas dans la technique antérieure. Les courants de fuite sont donc rendus très faibles (de plusieurs ordres de grandeur au dessous du picoampère), autorisant la mesure de courants extrêmement faibles.

L'injection de charges à travers la couche isolante mince peut se faire par claquage d'une jonction semiconductrice placée au dessous d'elle, ou encore par effet tunnel, portant à un potentiel relativement élevé, par influence capacitive, la couche conductrice reliée à l'électrode de collection de charges. Des explications plus détaillées seront données dans la suite de la description.

Le transistor de détection de la compensation de charges peut être l'un des transistors d'entrée d'un amplificateur différentiel couplé au circuit d'injection de charges.

La sortie de cet amplificateur peut être reliée à un convertisseur tension-fréquence établissant des impulsions calibrées destinées à l'injection de charges, la mesure du courant s'effectuant par mesure de la fréquence de sortie du convertisseur.

D'autres caractéristiques et avantages de l'invention apparaîtront à la lecture de la description détaillée qui suit et qui est faite en référence aux dessins annexés dans lesquels:

— la figure 1 représente schématiquement une vue de dessus d'un exemple de structure selon l'invention;

— la figure 2 représente une vue en coupe verticale selon la ligne A—A de la figure 1;

— la figure 3 représente, en coupe verticale, une variante d'un moyen d'injection de charges de compensation dans l'électrode collectrice.

Dans toute cette description on parlera d'appareil de mesure de courant de manière générale, étant entendu qu'il peut aussi s'agir d'un appareil de détection de courant ou d'un convertisseur courant-fréquence même si aucun affichage de valeur de courant n'est effectivement réalisé.

La structure représentée est intégrée sur un substrat de silicium monocristallin et réalisée selon une technologie de fabrication de type MOS (Métal-Oxyde-Semiconducteur) à grille de silicium polycristallin. D'autres technologies sont cependant possibles, comme par exemple une technologie sur substrat isolant d'alumine.

Le courant à mesurer provient par exemple de charges électriques résultant de l'ionisation d'un gaz. Ces charges sont recueillies par une électrode conductrice de collection de charges qui peut être soit une électrode déposée sur le substrat semiconducteur, soit une plaquette métallique indépendante du substrat et reliée électriquement aux éléments de circuit formés sur le substrat. La surface de cette électrode peut être de quelques millimètres carrés à titre d'exemple.

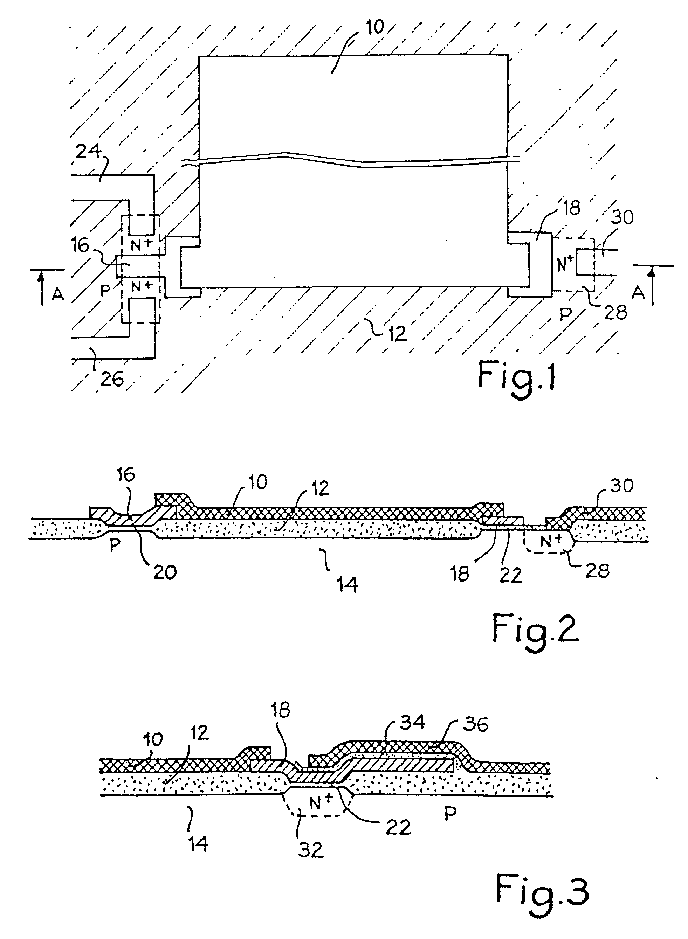

Dans l'exemple plus précisément décrit en référence aux figures 1 et 2, l'électrode est constituée par une couche d'aluminium 10 déposée sur une couche d'oxyde de silicium épais 12 formée sur un substrat de silicium monocristallin 14. Cette électrode est dénudée sur la majeure partie de sa surface supérieure pour pouvoir recueillir les charges à collecter, alors que le reste du circuit formé sur le substrat peut être recouvert d'une couche de passivation, non représentée pour faciliter la lisibilité des schémas.

L'électrode conductrice est reliée directement d'une part à la grille de silicium polycristallin 16 d'un transistor à effet de champ à grille isolée formé dans le substrat 14 et d'autre part à une autre couche conductrice, 18, en silicium polycristallin.

Alors que l'électrode d'aluminium repose en général sur de l'oxyde épais 12, les couches de silicium polycristallin 16 et 18 reposent sur des portions de couches minces isolantes 20 et 22 respectivement, de préférence aussi en oxyde de silicium.

L'aluminium de l'électrode 10 repose partiellement sur les couches de silicium polycristallin 16 et 18 pour effectuer le contact électrique entre ces couches et l'électrode de collection de charges.

L'électrode 10 n'est pas autrement reliée aux autres éléments de circuit de l'appareil de mesure, de sorte qu'elle constitue globalement une électrode flottante isolée du substrat 14 de silicium, et donc des autres éléments de circuit, par les couches isolantes minces 20 et 22 d'une part et par d'autres couches isolantes telles que l'oxyde épais 12 d'autre part.

La grille 16 sert à la détection de l'accumulation de charges dans l'électrode 10; la couche 18 sert à l'injection de charges de compensation.

Le transistor MOS ayant pour grille la grille 16, possède une source et un drain visibles à la figure 1 en vue de dessus (régions en pointillés, par exemple de type $N^+$) pour un substrat de type P et des électrodes correspondantes 24 pour la source, 26 pour le drain.

Ces électrodes 24 et 26 sont reliées à un circuit d'amplification non représenté, formé sur le substrat monocristallin 14. Par exemple, le transistor MOS constitué par les éléments décrits ci-dessus est l'un des transistors d'une paire de transistors d'entrée d'un amplificateur différentiel, l'autre transistor ayant sa grille portée à un potentiel de référence, de sorte que les variations de charge de l'électrode collectrice 10, retransmises par la grille 16 du premier transistor, se traduisent par des variations de courant dans celui-ci, variations qui sont amplifiées et servent à contrôler le fonctionnement, d'un circuit d'injection de charges de compensation dans l'électrode 10.

On n'entrera pas dans le détail de tout le circuit d'injection de charges, qui n'est pas représenté à l'exception de l'élément final d'injection dans la couche 18 à travers l'oxyde mince 22. Le circuit d'injection peut comprendre, en aval de l'amplificateur différentiel non représenté, un convertisseur tension-fréquence établissant des créneaux d'amplitude calibrée et de durée limitée correspondant chacun à l'injection d'une quantité de charges bien définie de signe opposé à celui des charges accumulées sur l'électrode 10. Ces créneaux sont produits à une fréquence variable en fonction de la tension de sortie de l'amplificateur différentiel, de manière à injecter une quantité de charges d'autant plus grande que l'accumulation de charges sur l'électrode collectrice 10 est plus grande. A mesure que la compensation s'effectue, la fréquence diminue pour sé stabiliser à une valeur représentant le flux de charges arrivant sur l'électrode collectrice. C'est donc cette fréquence qui sert de mesure pour évaluer le courant incident.

Un élément final d'injection, représenté sur les figures 1 et 2, reçoit les créneaux du convertisseur pour effectuer l'injection des charges; dans le mode de réalisation des figures 1 et 2, cet élément comprend une portion de substrat (ici de type P), au dessous de la couche conductrice 18 et séparée d'elle par la couche mince d'oxyde 22. Cette portion constitue une zone d'injection de porteurs dans la couche 18.

Une jonction $N^+P$ est formée à l'aide de cette zone d'injection et d'une région 28 de type $N^+$ diffusée dans le substrat. Cette région 28 peut être formée par autoalignement après dépôt et gravure du silicium polycristallin de la couche 18 de sorte que la jonction arrive juste au dessous du bord de cette couche 18. Une électrode 30 vient en contact avec la région $N^+$ 28 pour appliquer entre cette région et le substrat les créneaux calibrés mentionnés ci-dessus.

Ces créneaux ont une amplitude suffisante pour assurer le claquage de la jonction (polarisation en inverse de la jonction), donc la création de nombreuses paires électrons-trous dans la zone de type P sous la couche isolante mince recouverte de silicium polycristallin, ces particules chargées ayant une énergie suffisante, grâce à la mise en avalanche de la jonction, pour que certaines d'entre elles, soumises au champ électrique existant entre substrat et couche 18, traversent le couche d'oxyde mince 22 et soiet injectées dans la couche 18 puis dans l'électrode de collection 10 en compensant partiellement les charges déjà présentes dans celle-ci.

Il peut être souhaitable, pour des raisons de symétrie, de prévoir également la possibilité d'une injection par mise en avalanche d'une autre jonction, de type P⁺ N, qui serait formée également sous le bord d'une couche analogue à la couche 18 et reposant également sur une couche mince isolante. Dans ce cas, cette jonction P⁺ N serait formée à l'intérieur d'un caisson de type N forme dans le substrat comme on le fait couramment en technologie CMOS (MOS complémentaires). Cette disposition permettrait d'injecter de manière plus symétrique, à travers l'une ou l'autre des jonctions, soit des électrons soit des tours, pour compenser une accumulation de charges positives ou négatives dans l'électrode collectrice.

A titre indicatif, les créneaux calibrés peuvent avoir une amplitude d'une vingtaine de volts et une durée d'environ 0,5 microseconde, leur fréquence pouvant varier de 1 Hz à 1 MHz. L'épaisseur de la couche mince d'oxyde 22 peut être de l'ordre de mille angströms comme d'ailleurs celle de la couche 20 d'oxyde de grille du transistor MOS de détection. Il est nécessaire que la qualité de l'oxyde au niveau de la zone d'injection soit excellente pour éviter les dégradations de structure pendant l'injection. On pourrait d'ailleurs utiliser une couche de nitrure de silicium de bonne qualité.

Les courants que l'on pourra mesurer avec cet appareil seront de l'ordre de $10^{-16}$ ampères à $10^{-10}$ ampères. Pour des valeurs supérieures, le dispositif n'a plus d'intérêt car il nécessiterait une injection de charges de compensation trop importante aboutissant à une dégradation de la couche d'oxyde 22.

Une variante de réalisation de la présente invention consiste à prévoir un élément d'injection de charges de compensation ne fonctionnant pas sur le principe de la mise en avalanche d'une diode mais sur l'injection directe de porteurs libres "chauds", c'est à dire d'énergie importante mais non comparable à l'énergie provoquée par une mise en avalanche, ces porteurs circulant librement sous une couche d'oxyde très mince (de l'ordre de 100 à 200 angströms au plus) et l'injection se faisant par effet tunnel à travers cette couche sous l'effet d'un champ électrique élevé au sein de cette couche d'oxyde; ce champ est établi par influence capacitive.

La figure 3 montre en coupe verticale un exemple de réalisation de cette variante. On n'a pas représenté à nouveau le transistor de détection mais seulement l'électrode collectrice 10 en aluminium, reposant sur la couche d'oxyde épais 12 recouvrant le substrat 14 et venant en contact à une extrémité avec une couche de silicium polycristallin 18 qui est isolée du substrat 14 sur une petite surface (de l'ordre de 10 microns carrés) par une couche 22 d'oxyde de silicium d'environ 100 angströms d'épaisseur. La couche 18 est complètement isolée par ailleurs du substrat et du reste du circuit par de l'oxyde plus épais. Au dessous de la surface où la grille 18 n'est séparée du substrat que par cette couche très mince 22, on a prévu une région 32 de type de conductivité (N⁺) opposé à celui du substrat (P). Une électrode non représentée peut être connectée à cette région 32 pour y appliquer un potentiel désiré. La région 32 joue le rôle de zone d'injection de porteurs.

Par ailleurs, la couche 18, qui s'étend sur une surface beaucoup plus importante que la surface où elle n'est isolée du substrat que par une couche d'oxyde très mince, est recouverte d'une autre couche isolante 34 par exemple une couche d'oxyde de silicium ou de nitrure de silicium de plusieurs centaines d'angströms, elle-même recouverte d'une électrode de commande conductrice 36 par exemple en aluminium.

Le recouvrement de l'électrode 36 et de la grille 18 se fait sur une surface suffisamment importante par rapport à la surface de recouvrement de la couche 18 et de la région 32 recouverte par la couche très mince 22, pour que, compte-tenu des épaisseurs différentes des couches isolantes 22 et 34 et compte-tenu éventuellement des différences de permittivité diélectrique des matériaux qui composent ces couches, la capacité du condensateur formé entre les couches conductrices 18 et 36 soit très supérieure à la capacité existant entre les couches 18 et 10 d'une part et la région 32 de type N⁺ et le substrat d'autre part.

Si on applique une tension d'environ 20 volts, par impulsions de durée calibrée, entre l'électrode 36 et la région 32, cette tension se reporte essentiellement entre les armatures de la capacité la plus petite, à savoir entre la couche 18 et la région 32; il en résulte un champ très élevé à travers l'épaisseur de l'oxyde de la couche 22, suffisant pour provoquer une injection d'électrons ou de trous (selon le sens de la différence de potentiel appliquée) dans la couche 18 donc dans l'électrode de collection de charges 10. C'est donc la deuxième électrode métallique 36 qui sert à communiquer aux porteurs engendrés dans la région semiconductrice 32, une énergie suffisante pour assurer leur passage à travers la couche isolante très mince 22.

A titre d'exemple, la surface de recouvrement des électrodes 36 et de la grille 18 peut être de l'ordre de 100 à 200 microns carrés (pour une surface de l'électrode 10 inférieure à environ 10 000 à 20 000 microns carrés).

Ce deuxième mode de réalisation présente l'avantage de consommer moins d'énergie que le premier, et de permettre, avec un seul élément d'injection, la compensation de charges positives ou négatives, selon le sens de la différence de potentiel entre l'électrode 36 et la zone d'injection 32. Cependant, il nécessite une excellente qualité de l'oxyde très mince 22.


## Revendications

1. Appareil de mesure de courants très faibles, caractérisé en ce qu'il comprend:
— une électrode conductrice (10) de collection de charges électriques dont le flux constitue le courant à mesurer;
— un moyen (16, 20, 24, 26) de détection de la quantité de charges accumulées dans l'électrode de collection, ce moyen comprenant un transistor à effet de champ à grille isolée dont la grille (16) est électriquement reliée à l'électrode de collection (10);
— un circuit d'injection de charges de compensation comprenant au moins une couche conductrice (18) reliée à l'électrode de collection et une zone semiconductrice d'injection de porteurs (14; 32), cette zone étant séparée de la couche conductrice (18) par une couche isolante mince (22), et un moyen (28, 30; 34, 36) pour communiquer à des porteurs de la zone semiconductrice une énergie suffisante pour leur permettre de traverser l'épaisseur de la couche isolante mince (22), ce moyen fonctionnant pendant des intervalles de temps de durée et/ou de fréquence fonction du courant passant dans le transistor à effet de champ;
— l'électrode de collection étant maintenue isolée en courant continu du reste du circuit par des couches isolantes incluant ladite couche isolante mince et l'isolant de grille du transistor à effet de champ.

2. Appareil de mesure selon la revendication 1, caractérisé par le fait que le moyen pour communiquer à des porteurs de la zone d'injection une énergie suffisante comprend une jonction semiconductrice entre la zone d'injection (14) et une autre zone (28) de type de conductivé opposé, et un moyen pour appliquer à cette jonction des créneaux de tension en polarisation inverse de manière à la mettre en régime d'avalanche.

3. Appareil de mesure selon la revendication 1, caractérisé par le fait que le moyen pour communiquer à des porteurs de la zone d'injection une énergie suffisante comprend une électrode de commande (36) isolée de la couche conductrice (18) liée à l'électrode de collection, et un moyen pour appliquer des créneaux de tension entre la zone semiconductrice d'injection de porteurs (32) et l'électrode de commande (36).

4. Appareil de mesure selon la revendication 3, caractérisé par le fait que la capacité entre l'électrode de commande (36) et la couche conductrice (18) est très supérieure à la capacité entre la couche conductrice (18) et la zone semiconductrice d'injection (32).

5. Appareil de mesure selon l'une des revendications 1 à 4, carctérisé par le fait que le transistor à effet de champ est l'un des transistors d'une paire de transistors d'entrée d'un amplificateur différentiel, l'autre transistor de la paire ayant sa grille portée à un potentiel de référence.

6. Appareil de mesure selon l'une des revendications 1 à 5, caractérisé par le fait que la sortie de l'amplificateur différentiel commande un convertisseur tension-fréquence établissant des créneaux de tension de fréquence variable dans le circuit d'injection de charges de compensation.


## Patentansprüche

1. Gerät zur Messung sehr schwacher Ströme, dadurch gekennzeichnet, daß es aufweist:
— eine leitende Elektrode (10) zum Sammeln von elektrischen Ladungen, deren Fluß den zu messenden Strom bildet;
— ein Mittel (16, 20, 24, 26) zur Ermittlung der auf der Sammelelektrode akkumulierten Ladungsmenge, mit einem Feldeffekttransistor, dessen Gage (16) isoliert ist und elektrisch an die Sammelelektrode (10) angeschlossen ist;
— einen Schaltkreis zur Injektion von Kompensationsladungen mit mindestens einer leitenden Schicht (18), die an die Sammelelektrode angeschlossen ist, und einer halbleitenden Ladungsträgerinjectionszone (14; 32), die gegen die leitende Schicht (18) durch eine dünne isolierende Schicht (22) isoliert ist, sowie mit einem Mittel (28, 30; 34, 36), um den Ladungsträgern der halbleitenden Zone eine Energie zu übermitteln, die ausreicht, um ihnen den Durchtritt durch die Dicke der dünnen isolierenden Schicht (22) zu erlauben, wobei dieses Mittel während Zeitintervallen arbeitet, deren Dauer und/oder Frequenz vom Strom abhängt, der im Feldeffekttransistor fließt;
— wobei die Sammelelektrode gleichstrommäßig gegen den übrigen Schaltkreis durch isolierende Schichten einschließlich der genannten dünnen isolierenden Schicht und dem Gate-Isolator des Feldeffekttransistors isoliert gehalten wird.

2. Meßgerät nach Anspruch 1, dadurch gekennzeichnet, daß das Mittel, mit dem den Ladungsträgern de Injektionszone eine ausreichende Energie übermittelt wird, einen Halbleiterübergang zwischen der Injektionszone (14) und einer weiteren Zone (28) eines entgegengesetzten Leitfähigkeitstyps sowie ein Mittel aufweist, um an diesen Übergang Spannungsimpulse einer entgegengesetzten Polarität anzulegen, so daß diese Zone in den Lawinenmodus gelangt.

3. Meßgerät nach Anspruch 1, dadurch gekennzeichnet, daß das Mittel, mit dem den Ladungsträgern der Injektionszone eine ausreichende Energie übermittelt wird, eine Steuerelektrode (36), die gegen die mit der Sammelelektrode verbundene leitende Schicht (18) isoliert ist, und ein Mittel aufweist, um Spannungsimpulse zwischen die halbleitende Ladungsträgerinjektionszone (32) und die Steuerelektrode (36) anzulegen.

4. Meßgerät nach Anspruch 3, dadurch gekennzeichnet, daß der Kapazitätswert des zwischen der Steuerelektrode (36) und der leitenden Schicht (18) eingefügten Kondensators wesentlich größer als der Kapazitätswert des Kondensators ist, der zwischen der leitenden Schicht (18) und der halbleitenden Injektionszone (32) liegt.

5. Meßgerät nach einem der Ansprüche 1 bis 4, dadurch gekennzeichnet, daß der Feldeffekttransistor zu einem Paar von Eingangstransistoren eines Differentialverstärkers gehört, dessen anderer Transistor mit seinem Gate an einem Bezugspotential liegt.

6. Meßgerät nach einem der Ansprüche 1 bis 5, dadurch gekennzeichnet, daß der Ausgang des Differentialverstärkers einen Spannungs-Frequenzwandler steuert, der Spannungsimpulse variabler Frequenz im Schaltkreis zur Injektion von Kompensationsladungen bildet.

**Claims**

1. A device for measuring very low currents, characterized in that it comprises:

— a conducting electrode (10) for collecting electrical charges, the flux of which constitutes the current to be measured;

— a means (16, 20, 24, 26) for detecting the quantity of charges accumulated in the collection electrode, this means comprising a field effect transistor with insulated gate, the gate (16) of which is electrically connected to the collection electrode (10);

— a circuit for injecting compensation charges comprising at least one conducting layer (18) which is connected to the collection electrode, and a semiconducting zone for injecting charge carriers (14; 32), said zone being separated from the conducting layer (18) by a thin insulating layer (22), and comprising a means (28, 30; 34, 36) for communicating to the charge carriers of the semiconducting zone an energy which enables the carriers to pass through the thickness of the thin insulating layer (22), this means operating during time intervals the duration and/or frequency of which depends on the current passing through the field effect transistor;

— the collection electrode being kept insulated for direct currents from the remaining circuit by insulating layers including said thin insulating layer and the gate insulator of the field effect transistor.

2. A measuring device according to claim 1, characterized in that the means for communicating a sufficient energy to the charge carriers of the injection zone comprises a semiconducting junction between the injection zone (14) and a further zone (28) of opposed conductivity type, and a means for applying voltage pulses of opposite polarity to said junction in such a way that this junction is put into the avalanche mode.

3. A measuring device according to claim 1, characterized in that the means for communicating a sufficient energy to the charge carriers of the injection zone comprises a control electrode (36) which is insulated from the conducting layer (18) connected to the collection electrode, and a means for applying voltage pulses between the semiconducting charge carrier injection zone (32) and the control electrode (36).

4. A measuring device according to claim 3, characterized in that the capacitance of the capacitor between the control electrode (36) and the conducting layer (18) is substantially higher than the capacitance of the capacitor included between the conducting layer (18) and the semiconducting injection zone (32).

5. A measuring device according to one of claims 1 to 4, characterized in that the field effect transistor belongs to a pair of input transistors of a differential amplifier, the other transistor of the pair having is gate connected to a reference potential.

6. A measuring device according to one of claims 1 to 5, characterized in that the output of the differential amplifier controls a voltage-frequency converter which establishes voltage pulses of variable frequency in the circuit for injecting compensation charges.

0 108 676

Fig.1

Fig.2

Fig.3

1